# EUROPEAN PATENT APPLICATION

(11) **EP 0 637 196 A1**
(43) Date of publication of application: **01.02.1995**
(21) Application number: 93905673.5
(22) Date of filing: 15.01.1993
(51) Int. Cl.: H01L 21/56, H01L 21/68, H01L 23/31, H01L 23/495

(54) **PROCESS FOR MANUFACTURING INTEGRATED MICROCIRCUITS**

(71) Applicant: SANDEROV, Vilyam Lazarevich, Zelenograd, Moscow, 103498 (RU); TSAREV, Viktor Nikolaevich, Zelenograd, Moscow, 103482 (RU); DYAKOV, Jury Nikolaevich, Zelenograd, Moscow, 103305 (RU); POPOV, Alexandr Anatolievich, Moscow, 103460 (RU); EREMEEV, Mikhail Petrovich, Zelenograd, Moscow, 103536 (RU); MOROZOV, Vyacheslav Viktorovich, Zelenograd, Moscow, 103460 (RU)
(72) Inventor: SANDEROV, Vilyam Lazarevich, Zelenograd, Moscow, 103498 (RU); TSAREV, Viktor Nikolaevich, Zelenograd, Moscow, 103482 (RU); DYAKOV, Jury Nikolaevich, Zelenograd, Moscow, 103305 (RU); POPOV, Alexandr Anatolievich, Moscow, 103460 (RU); EREMEEV, Mikhail Petrovich, Zelenograd, Moscow, 103536 (RU); MOROZOV, Vyacheslav Viktorovich, Zelenograd, Moscow, 103460 (RU)
(74) Representative: W.P. Thompson & Co.
(86) International application number: RU9300008
(87) International publication number: WO9416544

(57) **Abstract**

The process involves: initially gluing a semiconducting crystal (7) at the face bearing the contact surfaces (8) to a polymer film (1); arranging and securing the polymer film (1) in a compression mould (13) so as to create a gap (14) between the surface of the compression mould (13) and the polymer film (1) along its entire length except in the vicinity of the contact surfaces (8); shaping the polymer substrate (23) of the integrated microcircuit; removing the polymer film (1) from the contact surfaces (8); heat-treating the substrate (23) and creating electrical connections between the contact surfaces (8) and the metal output terminals of the terminal frame.

## Description

### Technical Field

The present invention relates to semiconductor devices manufacturing means and specifically to a method of manufacture of integrated.

### Background Art

There is known a method of the manufacture of semiconductor devices consisting in that a semiconductor element is installed on an insulating base provided with a conducting pattern of connections following which, the element and the base are encapsulated. The element with its leads welded on to it is bonded to the base upon which the external ends of the leads are connected to the base pattern elements and encapsulated with a plastic material (JP, A, 63-9372).

To implement the method, it is necessary first to weld the leads onto the crystal and, when fitting the crystal in the through channel of the package, to form these leads around a plate which is an element of the package in its turn. These operations make the method complicated and unreliable. Besides, in the process of potting the channel with the encapsulating polymer, there is a probability of contact of one of the electrodes and the crystal edge which will result in the device failure.

There is also known a method of the manufacture of integrated circuits according to which a polyimide film is secured on the surface of a metal lead frame, and holes corresponding to the bonding pads of the crystal are made in the film using the photolithography method. The crystal is bonded to the film referring to the above-mentioned holes and its edge, in so doing, is protected with the film. This done, the electrical connections of the crystals bonding pads and lead frame terminals are formed and the crystal jointly with the lead frame and film are moulded thus forming an integrated circuit substrate (JP, A, 57-55310).

The photolithography operation and also the operation of etching holes in the film make the described method rather complicated in implementation and do not ensure a high output of serviceable articles. Besides, the connections of the film and crystal inside the holes are not sufficiently reliable which also negatively tells on the output of the serviceable articles.

### Disclosure of the Invention

The principal object of this invention is to provide a method of manufacture of integrated circuits which would allow increasing the output of serviceable articles and improving their reliability by creating conditions excluding the breaks of conductors in the process of encapsulation.

The foregoing object is attained by a method of manufacture of integrated circuits consisting in that a semiconductor crystal of an integrated circuit is installed on a polymeric film and jointly with a lead frame with metal leads are encapsulated with a polymeric material, in so doing, electric connection between the semiconductor crystal bonding pads and respective metal leads is formed, according to the invention, initially the semiconductor crystal is bonded to the polymeric film with its bonding pads side, the polymeric film is placed and secured in a mould so that a clearance between the surface of the mould and the polymeric film is formed along the whole length except for the places of location of the semiconductor crystal bonding pads, a polymeric substrate of the integrated circuit is formed, the polymeric film is removed from the crystal bonding pads, the polymeric substrate is subjected to thermal treatment and electrical connections of the crystal bonding pads with the lead frame metal leads are formed.

It is expedient that the semiconductor crystal should be oriented in the process of bonding by means of reference signs on a mask or by means of reference holes on the polymeric film, or, reference signs should be applied on the polymeric film after the semiconductor crystal is bonded which would allow orienting the polymeric film in a mould.

On the surface of the mould, it is permissible to make projections corresponding to the location of the semiconductor crystal bonding pads and intended for installing the semiconductor crystal with its bonding pads in order to form a clearance, and also to secure the polymeric film with the crystal in the mould by means of mechanical force applied to the semiconductor crystal and having a value exceeding that of the transfer moulding specific pressure.

It is further expedient that the electrical connections of the bonding pads with the metal leads should be formed by the evaporation of film conductors and a protective coating should be applied on the integrated circuit surface on which the film conductors are evaporated.

It is desirable in a number of cases that additional electrical connections between the bonding pads and metal leads should be formed with the aid of wires connected to the film conductors.

### Brief Description of Drawings

The invention will be further described by way of the concrete examples of its embodiment with reference to the accompanying drawings, wherein:
Fig. 1 a, b, d represents the installation of a semiconductor crystal on a polymeric film according to the invention;
Fig. 2 a, b, c illustrates one more version of the semiconductor crystal installation on the polymeric film;
Fig. 3 a, b, c shows the installation of a lead frame and the semiconductor crystal on the polymeric film;
Fig. 4 a, b, c represents the versions of the installation of the film with the crystal and lead frame in a mould according to the invention;
Fig. 5 represents the securing of the semiconductor crystal in the mould according to the invention;
Fig. 6 shows the formation of an integrated circuit polymeric substrate according to the invention;
Fig. 7 illustrates the removal of the polymeric film after the extraction of the substrate from the mould;
Fig. 8 represents the evaporation of film conductors according to the invention;
Fig. 9 illustrates an integrated circuit with a protective coating and encapsulating shell in compliance with the invention;
Fig. 10 illustrates the same integrated circuit with additional electrical connections according to the invention.

### Best Embodiment of the Invention

The claimed method of manufacture of integrated circuits consists in accomplishment of the following operations.

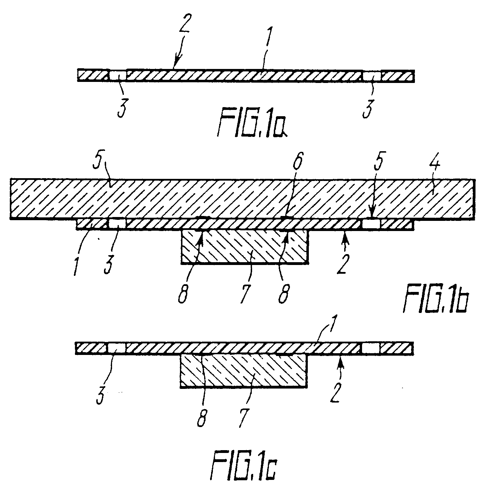

Applied on one side of a polymeric film 1 (Fig. 1) is a layer 2 (Fig. 1a) of an adhesive and reference holes 3 are made in the film 1.

This donw, the film 1 is installed on a mask 4 (Fig. 1b) relative to his reference holes 3 and reference signs 5 of the mask, following which, a semiconductor crystal 7 is oriented relative to other reference signs 6 of the mask 4 and bonded with its bonding pads 8 side to the film 1 (Fig. 1b). After this, the film 1 with bonded to it crystal 7 is removed from the mask 4 (Fig. 1b, c). It is also possible to bond several crystals or other electronic components to the film, in so doing, all other operations of the method are performed in a similar manner for all crystals.

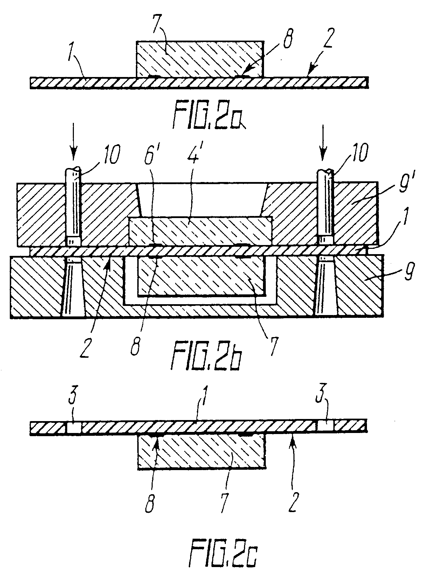

However, the crystal 7 may be bonded directly to the film 1 without preliminary orientation, as shown in Fig. 2a. After bonding, the film 1 with the crystal 7 (Fig. 2b) is installed in a press tool 9 so that the bonding pads 8 of the crystal 7 are coincident with reference signs 6^{l} of the mask 4^{l} secured in the upper part 9^{l} of the press tool 9. This done, the reference holes 3 (Fig. 2 c) are made in the film 1 with the aid of punches 10 (Fig. 2) and the film 1 jointly with the crystal 7 is taken out of the press tool 9 (Fig. 2b).

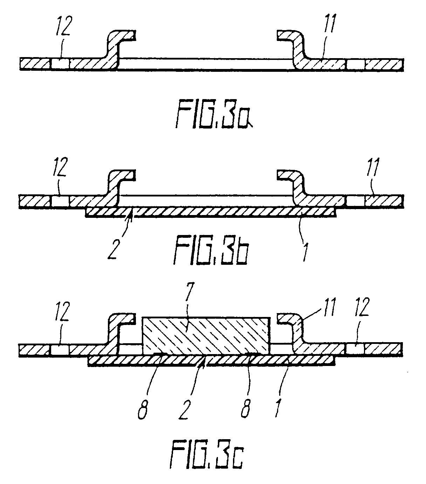

Besides, there exists one more version of oriented bonding of the crystal 7 to the film 1. According to this version, a lead frame 11 (Fig. 3a) with reference holes 12 made in it is bonded to the film 1 (Fig. 3b), following which, the crystal 7 (Fig. 3c) is oriented relative to the reference holes 12 and bonded to the film 1 with the side having the bonding pads 8.

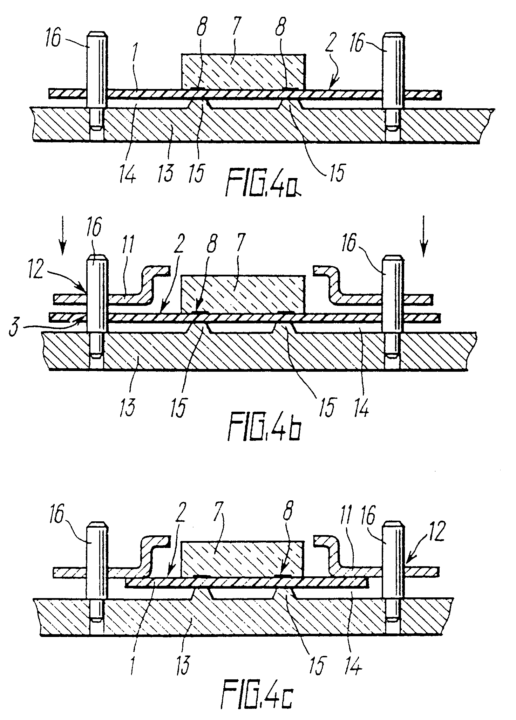

The film 1 (Fig. 4a) with the crystal 7 bonded to it is placed and fixed in a mould 13 so that a clearance 14 is formed along the whole length between the surface of the mould 13 base and the surface of the film 1 except for the places of location of the bonding pads 8. For this purpose, provision is made for projections 15 on the surface of the mould 13. The projections correspond to the bonding pads 8 and the orientation is performed with the aid of pins 16 corresponding to the reference holes 3 of the film 1 and also to the reference holes 12 (Fig. 4 b) of the lead frame 11 which is installed after the film 1.

If the crystal 7 is oriented as shown in Fig. 3, the film 1 (Fig. 4) in the mould 13 is oriented only with respect to the reference holes 12 of the lead frame 11.

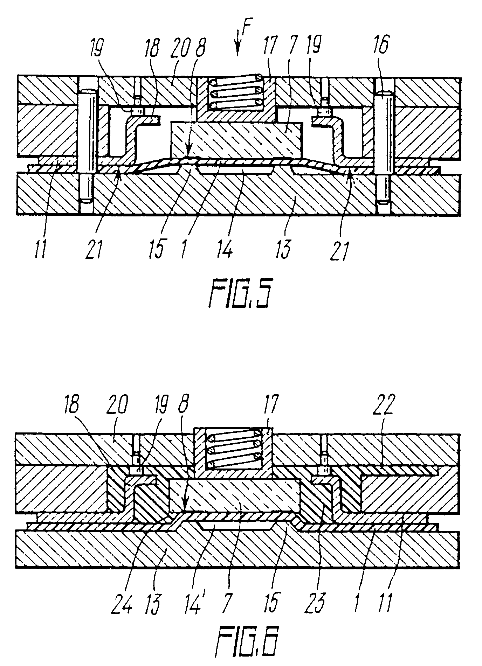

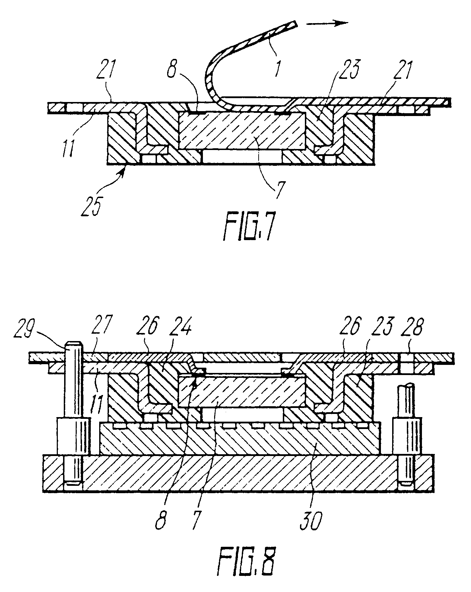

The film 1 (Fig. 5) with the crystal 7 is fixed in the mould 13 by means of a mechanical force which is applied to the crystal 7 through a spring-loaded pin 17 of the mould 13. The value of force F should be greater than that of the transfer moulding specific pressure.

At the same time, the above-mentioned force F provides for a tight hermetically sealed contact of the crystal 7 and the film 1 (the latter is subjected to plastic deformation under the action of the transfer moulding temperature and the pressure exerted by the end face of the projection 15) and prevents possible displacement of the crystal 7 in the transfer moulding process when a load is applied to the side ribs of the crystal. Besides, the force ensures the fixing of the crystal 7 during deformation of the film 1.

Simultaneously, the horizontal sections of leads 18 of the lead frame 11 are tightened up by projections 19 located on a cover 20 of the mould 13 in the direction perpendicular to the side of the crystal 7 carrying the bonding pads 8, which excludes the penetration of the polymeric material to the surface of current conducting sections 21 of the lead frame 11 due to the plastic deformation of the film 1.

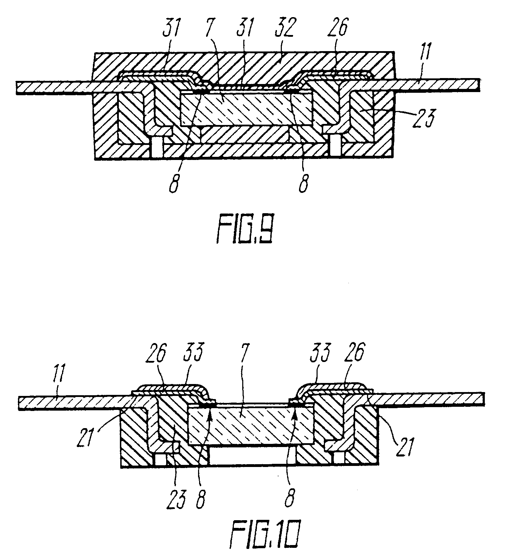

The mould 13 (Fig. 6) is potted with a polymeric material through a pouring gate 22. The material fills the space of the mould and forms a substrate 23 of the future integrated circuit. In this case, the clearance 14¹ between the projections 15 of the mould 13 serves as an insulayed air collector used in the process of the transfer moulding for the removal of air available under the film 1 and, consequently, for proper formation of a projection 24 over the edge of crystal 7 all around its periphery before the bonding pads 8.

After hardening of the polymeric material of the substrate 23, an article 25 (Fig. 7) is taken out of the mould 13 (Fig. 6) and the film 1 is removed from the crystal 7. The article 25 is cleaned of adhesive from the film 1 in, for example, air plasma and is subjected to thermal treatment in order to polymerize the polymeric material of the substrate 23 in a shielding medium, for example, in nitrogen. The bonding pads 8 are cleaned of the oxide film by any of the known methods, for example, by chemical treatment, ion-beam cleaning or plasma-and-chemical treatment, following which, the electrical connections of the bonding pads 8 of the crystal 7 with the current conducting sections 21 of the leads of the lead frame 11 are formed.

The electrical connections are formed by way of the evaporation of film conductors 26 (Fig. 8), for example, with the use of the vacuum evaporation technique through a magnetic mask 27. Used as a material for the conductors 26 is aluminium sometimes with a vanadium sublayer. It is also possible to apply the conductors by filling through a templet. The mask 27 with reference holes 28, corresponding to the holes 12 of the lead frame 11, is installed on pins 29 and pressed to the surface of the article with the aid of a magnet 30, following which, the conductors 26 are evaporated by means of resistive or electron-beam evaporators (not represented in the drawing).

After evaporation of the conductors 26, a protective coating 31 (Fig. 9) is applied in an inert dried medium, for example, in that of photoresist, on the surface of the substrate 23 including the crystal 7 with its bonding pads 8, and on the surface of the conductors 26.

This done, the integrated circuit is finally encapsulated by way of forming an encapsulating shell 32 (Fig. 9) from the polymeric material (from which the substrate 23 is formed) in the process of the transfer moulding.

In some cases, however, it is expedient before final encapsulation to form additional electrical connections, for example, in the form of wire connections 33 (Fig. 10) between the bonding pads 8 of the crystal 7 and the current conducting sections 21 of the lead frame 11 which are connected to the film conductors 26 using any of the known methods.

Described below is an example of embodiment of the claimed method of manufacture of integrated circuits.

### Example

The crystal 7 in the oriented position and the lead frame 11 with the reference holes 12 are bonded to the polymeric film 1, in our particular case to the 40 m thick polyimide film 1 with a layer 2 of adhesive of 2 to 5 m in thickness applied to one of its sides. The crystal 7 is bonded with its side having the bonding pads 8 turned towards the film 1. The lead frame 11 is bonded in such a manner that the centres of the reference holes 12 on the frame are installed with an accuracy of at least ±0.015 mm relative to the reference signs of the crystal 7.

Used as reference signs are the bonding pads 8 of the crystal 7. Prior to installing the lead frame 11 on the pins 16, the internal ends of the frame are made L-shaped. Used as a material of the lead frame 11 is an aluminium alloy. The thickness of the lead frame is 0.1 to 0.15 mm. The lead frame 11 is coated with a 0.006 mm thick tin-nickel layer. The film 1 with the crystal 7 and lead frame 11 assembled on it is installed in the mould 13 so that reference pins 16 of the mould enter the reference holes 12 of the load frame 11. When installing the moulding matrixes of the mould 13, the crystal is tighten up from its reverse side to the projections 15 of the mould 13 with the aid of pin 17 and also the horizontal fastening L-shaped sections of the lead frame 11 are pressed down with the aif of the cone metal projections 19. The projections 15 of the mould 13 are of a closed type and have rectangular or other shape corresponding to the location topology of the bonding pads 8. The external side surface of the projection 15 is inclined towards the base of the mould 13. When the film 1 with the crystal 7 is imposed, the clearance 14 is formed inside the contour limited by the external side surface of the projection 15. The width of the end face of the projection 15 is so selected as to ensure a specific pressure (when pressing down the crystal 7) which would provide qualitative potting with the polymeric material and at the same time would not exceed the mechanical strength of the crystal 7. For instance, use may be made of a 0.25 mm wide projection.

After assembly of the mould 13, the transfer moulding of the integrated circuit is performed with the use of a plastic material for instance. For the purpose use is made of an epoxy moulding material at a moulding temperature of 160±5°C, specific pressure of 5.0 MPa and a curing time in the mould (thermal stabilization) of 5 min. Moulding materials are also used at a moulding temperature of 180±5°C, specific pressure of 3.5 to 7.0 MPa and a curing time of 2 min.

After hardening of the polymeric material, the article is taken out of the mould and the film 1 is removed. Following this, the working surface of the article is cleaned of the remaining adhesive in an air plasma and is subjected to thermal treatment for polymerization which is performed in nitrogen at a temperature of 180°C for 4 to 5 h.

This donw, the bonding pads 8 of the crystal 7 are cleaned of the oxide film Al₂O₃ and the film conductors 26 are applied by the vacuum evaporation through the magnetic mask 27 made of 0.1 mm thick nickel alloy. Used as a material of the film conductors 26 is aluminium alloy with a vanadium sublayer and their thickness is equal to 5 m.

When the film conductors 26 are applied by means of resistive or electron-beam evaporators there must be a clearance of 35 to 40 mm between the mask 27 and the crystal 7, when use is made of a magnetron evaporator the above-mentioned clearance must be equal to approximately 10 m. As soon as the module is taken out of the vacuum evaporating unit, the crystal 7, its contacts 3 and film conductors are given the thin protective coating 31 applied in an inert dried medium. Specifically, a photoresist layer of 10 to 15 mm in thickness is applied and hardened. Later on the module is finally encapsulated using the transfer moulding.

The manufacturing cycle of integrated circuits is completed by the operations of cutting and forming the leads and inspecting the electrical parameters.

In the claimed method of manufacture of integrated circuits it is possible to improve the reliability of the devices as a result of formation of the film conductors. It is found that it is possible to get rid of conductor breaks in the process of general encapsulation of the devices with a polymeric material which allows increasing the output of the serviceable devices. Besides, it is possible to increase the resolution in the process of formation of the film conductors and, consequently, to produce multilead integrated circuits.

### Industrial Applicability

The present invention may be widely used in the manufacture of semiconductor devices, specifically, of large-scale and very large scale integrated circuits, microwave circuits and other similar devices.

## Claims

1. A method of manufacture of integrated circuits consisting in that a semiconductor crystal of an integrated circuit is installed on a polymeric film, following which, the crystal, a lead frame with metal leads are incapsulated with a polymeric material forming an electrical connection of the semiconductor crystal bonding pads with respective metal leads, characterized in that initially the semiconductor crystal is bonded with its side having the bondings pads to the polymeric film, the film is placed and fixed in a mould so that a clearance is formed between the surface of the mould and the polymeric film along the while length except for the places of location of the semiconductor crystal bonding pads, a polymeric substrate of the integrated circuit is formed, the polymeric film is removed from the bonding pads, the polymeric substrate is subjected to thermal treatment and electrical connections of the bonding pads with the lead frame metal leads are formed.

2. The method as claimed in Claim 1, characterized in that the semiconductor crystal is oriented in the process of its bonding by means of reference signs on a mask or by means of reference holes in the polymeric film.

3. The method as claimed in Claim 1, characterized in that after the semiconductor crystal is bonded, reference signs allowing the orientation of the film in the mould are applied on the film.

4. The method as claimed in Claims 1, 2 or 3, characterized in that the projections corresponding to the location of the semiconductor crystal bonding pads are made on the mould surface and the semiconductor crystal is installed onto them with its bonding pads in order to form a clearance.

5. The method, as claimed in Claim 1 or 2 or 3, characterized in that the polymeric film with the semiconductor crystal is fixed in the mould by means of a mechanical force applied to the semiconductor crystal and having a value greater than that of the transfer moulding specific pressure.

6. The method as claimed in Claim 4, characterized in that the polymeric film with the semiconductor crystal in fixed in the mould by means of a mechanical force applied to the semiconductor crystal and having a value greater than that at the transfer moulding specific pressure.

7. The method as claimed in Claims 1 or 2, or 3, characterized in that the electrical connections of the bonding pads with the metal leads are formed by evaporation of the fiom conductors.

8. The method as claimed in Claim 4, characterized in that the electrical connections of the contact pads with the metal leads are formed by evaporation of the film conductors.

9. The method as claimed in Claim 7, characterized in that a protective coating is applied on the surface of the integrated circuit on which the film conductors are evaporated.

10. The method as claimed in Claim 8, characterized in that a protective coating is applied on the integrated circuit surface carrying the evaporated film conductors.

11. The method as claimed in Claim 7, characterized in that additional electrical connections between the bonding pads and metal leads are formed by means of wires applied on the film conductors.

12. The method as claimed in Claim 8, characterized in that additional electrical connections are formed between the bonding pads and metal leads by means of wires applied on the film conductors.
